# EUROPÄISCHE PATENTANMELDUNG

(11) **EP 4 807 941 A1**
(43) Veröffentlichungstag der Anmeldung: **16.09.2026**
(21) Anmeldenummer: 25162851.7
(22) Anmeldetag: 11.03.2025
(51) Int. Cl.: H02J 7/00, B25F 5/00, G01R 31/389, G01R 31/392, H01M 10/44

(54) **BETREIBEN EINES AKKUMULATORS**

(71) Anmelder: Hilti Aktiengesellschaft, 9494 Schaan (LI)
(72) Erfinder: Marin Goncalves, Jonathan Jesus, 7320 Sargans (CH); Musolino, Vincenzo, 9470 Buchs (CH)
(74) Vertreter: Hilti Aktiengesellschaft Corporate Intellectual Property

(57) **Zusammenfassung**

Die vorliegende Erfindung betrifft ein Verfahren zum Betreiben eines Akkumulators, welcher zum Versorgen einer mobilen Werkzeugmaschine, insbesondere einer tragbaren Werkzeugmaschine, mit elektrischem Strom eingerichtet ist, enthaltend: Messen eines Impedanz-Kennwerts zumindest einer Zelle des Akkumulators, und Beenden eines Entladens zumindest der Zelle bei Erreichen eines Spannungsgrenzwerts, welcher in Abhängigkeit des Impedanz-Kennwerts bestimmt ist.

## Beschreibung

### GEBIET DER ERFINDUNG

Die vorliegende Erfindung betrifft ein Verfahren zum Betreiben eines Akkumulators, welcher zum Versorgen einer mobilen Werkzeugmaschine, insbesondere einer tragbaren Werkzeugmaschine, mit elektrischem Strom eingerichtet ist. Außerdem betrifft die vorliegende Erfindung ein Computerprogrammprodukt, einen Akkumulator, ein Ladegerät und eine mobile Werkzeugmaschine.

Ein Akkumulator hat üblicherweise einen zweipoligen Stromanschluss. Diese Pole sind intern mit jeweiligen Polen von Akkumulatorzellen verschaltet. Es ist bekannt, eine Akkumulatorzelle (kurz: Zelle) mittels elektrochemischer Spektroskopie zu untersuchen. Allgemein gesprochen, wird dabei an die Pole der untersuchten Zelle ein Wechselstrom bei unterschiedlichen Frequenzen angelegt, und deren Impedanz bei den jeweiligen Frequenzen gemessen. Man erhält ein Impedanz-Frequenz-Verhalten, das als eine Kennlinie darstellbar ist, beispielsweise als Blindwiderstand über Ohm'scher Widerstand. Aus diesem Impedanz-Frequenz-Verhalten kann man einen Indikator (oder mehrere Indikatoren) für ein Alterungszustand der untersuchten Zelle ableiten. Beispielsweise kann man mittels eines DRT-Verfahrens ("distribution of relaxation times", eine Analyse auf Basis einer Verteilungsfunktion von Relaxationszeiten) einen Kathode-Ladungsübergang-Widerstandsindikator, einen Anode-Ladungsübergang-Widerstandsindikator und/oder einen Passivierungsschicht-Widerstandsindikator bestimmen. Diese Werte nehmen mit einer Anzahl an Ladevorgängen des Akkumulators zu und machen die Alterung eines Akkumulators messbar.

Akkumulatoren der Typen Blei-Säure-Akkumulator, Nickel-Metallhydrid-Akkumulator und Lithiumionen-Akkumulator haben ein Ladungs-abhängiges Spannungsprofil. Das bedeutet, dass ihre Zellspannung umso höher ist, je mehr sie geladen sind. Bei Blei-Säure-Zellen und Nickel-Metallhydrid-Zellen ist dies ein näherungsweise proportionaler Zusammenhang, und Lithiumionen-Zellen haben üblicherweise ein Plateau in einem mittleren Ladungsbereich. Bisher werden Zellen daher entladen, bis eine Spannung des Akkumulators bzw. der Zelle auf einen vordefinierten Wert abgesunken ist. Ein weiteres Absinken könnte zu einem sogenannten Tiefenentladen führen, das irreparabel ist. Der vordefinierte Wert ist beispielsweise bauartabhängig gewählt. Mit zunehmender Zyklenzahl bzw. Anzahl an Ladevorgängen altert die Zelle, das bedeutet, dass ihre effektive Kapazität abnimmt. Bei einer jungen Zelle wird daher mehr Ladung entladen als bei einer gealterten Zelle.

Unter einer "effektiven Kapazität" soll im Folgenden ein Unterschied zwischen einer Ladung in einem vollgeladenen Zustand und einer Ladung in einem entladenen Zustand verstanden werden. Man kann auch von einer nutzbaren Kapazität oder abgebbaren Ladung sprechen. Die effektive Kapazität einer Zelle nimmt also mit deren Lebenszeit (Anzahl an Aufladungsvorgängen) ab.

Eine Aufgabe der vorliegenden Erfindung ist es vor diesem Hintergrund, ein Mittel zum Erhöhen einer effektiven Kapazität eines Akkumulators unter Berücksichtigung von Alterungseffekten bereitzustellen.

### OFFENBARUNG DER ERFINDUNG

Demgemäß wird ein Verfahren zum Betreiben eines Akkumulators vorgeschlagen. Der Akkumulator ist zum Versorgen einer mobilen Werkzeugmaschine, insbesondere einer tragbaren Werkzeugmaschine, mit elektrischem Strom eingerichtet. Das Verfahren hat die Schritte: Messen zumindest eines Impedanz-Kennwerts zumindest einer Zelle des Akkumulators, und Beenden eines Entladens zumindest der Zelle bei Erreichen eines Spannungsgrenzwerts, welcher in Abhängigkeit des Impedanz-Kennwerts bestimmt ist.

Das Verfahren sieht also vor, nicht bis zu einem konstanten, rein bauartabhängigen Spannungsgrenzwert zu entladen, sondern bis zu einem veränderlichen, alterungsabhängigen Spannungsgrenzwert zu entladen. Der Spannungsgrenzwert ist eine untere Grenze für ein Entladefenster, das einen Spannungsbereich zum Entladen der Zelle vorgibt.

Der "Impedanz-Kennwert" ist für eine Impedanz der Zelle oder Zellen indikativ. Dabei kann es auch sein, dass der "Impedanz-Kennwert" für eine Impedanz eines Entladeteilprozesses der Zelle oder Zellen indikativ ist. Beispielsweise ist bei einer typischen Lithiumionen-Zelle ein Entladeprozess gegliedert in: einen Teilprozess eines Lösens des Lithiumions von der jeweiligen Kathode, einen Teilprozess eines Durchtritts des Lithiumions durch eine Passivierungsschicht (SEI, solid electrolyte interphase), einen Teilprozess eines Durchtritts des Lithiumions durch eine Isolationsschicht und einen Teilprozess eines Anbindens des Lithiumions an die jeweilige Anode. Es kann auch sein, dass das Verfahren mehrere Impedanz-Kennwerte verwendet.

Statt "Messen" des Impedanz-Kennwerts kann man sagen, dass der Impedanz-Kennwert "ermittelt" wird, und zwar mittels Messens zumindest einer Eigenschaft der Zelle. Der Impedanz-Kennwert wird vorzugsweise mittels Anlegens und/oder Aufprägens einer Wechselspannung an/auf die jeweilige Zelle ermittelt/gemessen.

Unter einem "angepassten Spannungsgrenzwert" soll ein in Abhängigkeit des Impedanz-Kennwerts bestimmter Spannungsgrenzwert verstanden werden. Unter einem "konstanten Spannungsgrenzwert" soll demgegenüber ein herkömmlicher, über die Lebensdauer der jeweiligen Zelle vorgegebener, bauartabhängig bestimmter und/oder konstant Spannungsgrenzwert verstanden werden. Unter einer "Zyklenzahl" soll die Anzahl an Lade- und Entladevorgängen einer individuellen Zelle bis zu einem bestimmten Zeitpunkt verstanden werden.

Die Anwendung des vorgeschlagenen Verfahrens hat je nach Zyklenzahl der Zelle unterschiedliche Effekte. Dabei wird nun von zwei ansonsten baugleichen Zellen A und B ausgegangen, von denen Zelle A nach dem vorgeschlagenen Verfahren betrieben und Zelle B regelmäßig bis zum konstanten Spannungsgrenzwert entladen wird. Bei einer niedrigen Zyklenzahl kann das Verfahren der Zelle A einen niedrigeren angepassten Spannungsgrenzwert als den konstanten Spannungsgrenzwert erlauben, sodass Zelle A zu dieser Zeit eine größere effektive Kapazität als Zelle B bietet. Bei einer mittleren Zyklenzahl führt das Verfahren zu einem höheren angepassten Spannungsgrenzwert als dem konstanten Spannungsgrenzwert, sodass die Zelle A in dieser Zeit eine etwas niedrigere effektive Kapazität als Zelle B bietet. Indem der Spannungsgrenzwert für die Zelle A mit mittlerer Zyklenzahl höher als der konstante Spannungsgrenzwert gewählt ist, wird jedoch ein weiteres Altern (Wachsen eines Betrags eines inneren Widerstands) der Zelle A verlangsamt. Dies führt dazu, dass Zelle A bei einer hohen Zyklenzahl wieder eine größere effektive Kapazität als Zelle B bietet. Hierauf ist das Bestimmen des angepassten Spannungsgrenzwerts ausgelegt. Dies ist in dreierlei Hinsicht von Vorteil: Erstens kann Zelle A über die Lebensdauer hinweg insgesamt mehr Ladung abgeben. Sie hat also insgesamt eine höhere effektive Kapazität als Zelle B. Zweitens kann Zelle A bei hoher Zyklenzahl noch eine höhere effektive Kapazität bieten und hat in dieser Zeit eine höhere effektive Kapazität. Man kann auch sagen, dass die über die Lebensdauer gesehen niedrigste Kapazität der Zelle A höher als bei Zelle B ist. Drittens wird Zelle B bei hoher Zyklenzahl häufiger wieder geladen, sodass die Zyklenzahl von Zelle B schneller steigt und Zelle B noch schneller altert.

An moderne Zellen werden in jeder Hinsicht hohe Anforderungen gestellt. Daher werden bei einer Entwicklung eines neuen Typs Zelle bzw. einer Weiterentwicklung eines Typs Zelle dessen Eigenschaften in aufwendigen Versuchsreihen ermittelt. Zum Ermitteln und Testen der vorgeschlagenen Abhängigkeit des Spannungsgrenzwerts von dem zumindest einen Impedanz-Kennwert ist zwar zusätzlicher Aufwand vonnöten, dieser macht allerdings nur einen verhältnismäßig kleinen Teil des gesamten Entwicklungs- und Versuchsaufwands aus.

Es kann sein, dass der zumindest eine Impedanz-Kennwert während eines Aufladens, während eines Bereitschaftsbetriebs und/oder während eines Entladens gemessen bzw. ermittelt wird. Unter dem Bereitschaftsbetrieb kann man jeden Betrieb verstehen, der nicht ein Aufladen und nicht ein Entladen ist. Man kann den Bereitschaftsbetrieb als einen Lagerbetrieb bezeichnen. Es wird also ein Messen des Impedanz-Kennwerts in einem normalen bzw. alltäglichen Betrieb des Akkumulators vorgeschlagen. Auf diese Weise kann ein aktueller Wert des Impedanz-Kennwerts ermittelt werden.

Es kann sein, dass ein Zustand der Zelle, während welchem der zumindest eine Impedanz-Kennwert gemessen wird, darauf eingeschränkt wird, dass eine Ladung der Zelle in einem definierten Bereich ist, beispielsweise von 20% bis 100% der (zuletzt ermittelten, beispielsweise über Messen von Spannungszeitverlauf und Stromstärkezeitverlauf) effektiven Kapazität. Vorzugsweise wird der Impedanz-Kennwert nur dann gemessen, wenn eine Temperatur des Akkumulators in einem definierten Bereich ist, beispielsweise zumindest 5°C und/oder höchstens 40°C beträgt.

Es kann sein, dass das Verfahren durch eine Akkumulator-interne Steuereinrichtung ausgeführt wird. Diese Variante hat den Vorteil, dass das Verfahren ohne ein speziell angepasstes Ladegerät und ohne eine speziell angepasste Werkzeugmaschine ausführbar ist.

Es kann sein, dass das Verfahren enthält: Reduzieren einer Stromstärke des Entladens bei Erreichen eines Spannungszwischengrenzwerts, welcher in Abhängigkeit des Impedanz-Kennwerts und/oder des Spannungsgrenzwerts bestimmt ist. Der Spannungszwischengrenzwert ist betragsmäßig größer als der Spannungsgrenzwert, beispielsweise beträgt er das 1,2-fache. Auf diese Weise kann ein Anwender durch einen Drehmomentabfall der Werkzeugmaschine vorgewarnt werden, dass das Entladen bald beendet wird. Es kann auch ein allmähliches Reduzieren der Stromstärke ab de Spannungszwischengrenzwert umgesetzt werden, sodass ein Sprung im Werkzeugmaschineverhalten vermieden wird.

Es kann sein, dass der Akkumulator eine unveränderliche bzw. feste Schaltung mehrerer Zellen hat (im Folgenden: Akkumulator mit unveränderlicher Zellenschaltung). Die Schaltung kann eine Reihenschaltung mehrerer Zellen, eine Parallelschaltung mehrerer Zellen, oder eine Kombination aus Parallelschaltung und Reihenschaltung sein (insb. Parallelschaltung mehrerer Reihenschaltungen, oder Reihenschaltung mehrerer Parallelschaltungen). Für solche Akkumulatoren mit unveränderlicher Zellenschaltung wird weiterbildend vorgeschlagen, dass a) der Impedanz-Kennwert für zumindest eine Zelle je einzeln gemessen wird, b) für jede Zelle, deren Impedanz-Kennwert gemessen ist, ein jeweiliger Spannungsgrenzwert bestimmt wird, und c) das Entladen beendet wird, falls bzw. wann eine Spannung einer Zelle deren Spannungsgrenzwert erreicht. Man kann auch sagen, dass der jeweilige Spannungsgrenzwert einzeln bestimmt wird. Das Verfahren enthält beispielsweise, eine Spannung jeder Zelle zu messen, deren Impedanz-Kennwert gemessen wird. Es kann auch sein, dass nur für einen Teil der Zellen die jeweilige Spannung gemessen bzw. direkt gemessen und für den restlichen Teil der Zellen die jeweilige Spannung berechnet bzw. indirekt gemessen wird. Diese Variante (jeweiliger Spannungsgrenzwert für jede gemessene Zelle) bietet den Vorteil einer besonders gut angepassten Entladegrenze. Für solche Akkumulatoren mit unveränderlicher Zellenschaltung wird außerdem, ebenfalls weiterbildend, vorgeschlagen, dass a) der Impedanz-Kennwert für mehrere oder alle Zellen des Akkumulators gemeinsam gemessen wird, b) für alle Zellen, deren Impedanz-Kennwert gemessen ist, ein gemeinsamer Spannungsgrenzwert bestimmt wird, und c) das Entladen des Akkumulators bei Erreichen des Spannungsgrenzwerts beendet wird. Diese Variante bietet einen effizienten Kompromiss.

Es kann sein, dass der Akkumulator eine veränderliche Schaltung aus mehreren Zellen hat. Mit anderen Worten, es kann sein, dass der Akkumulator dazu eingerichtet ist, mehrere Zellen je nach Leistungsbedarf und/oder je nach Ladung oder Temperatur der einzelnen Zellen zum Entladen in Reihe und/oder parallel zu schalten. Für einen solchen Akkumulator mit veränderlicher Schaltung wird vorgeschlagen, dass a) der Impedanz-Kennwert für jede Zelle je einzeln gemessen wird, b) für jede Zelle ein jeweiliger Spannungsgrenzwert bestimmt wird, und c) für jede Zelle ein Entladen beendet wird, falls die Spannung dieser Zelle deren Spannungsgrenzwert erreicht. Mittels dieser Verfahrensschritte kann ein Akkumulator aus vielen Zellen so betrieben werden, dass eine Leistungsabgabe des gesamten Akkumulators über dessen Lebensdauer maximiert wird.

Die erwähnte Abhängigkeit des Spannungsgrenzwerts bzw. des Bestimmens des Spannungsgrenzwerts von dem zumindest einen Impedanz-Kennwert bedeutet vorzugsweise, dass eine höhere Impedanz der Zelle einem zumindest nicht niedrigeren und vorzugsweise höheren Spannungsgrenzwert entspricht. Mit anderen Worten: die Abhängigkeit des Spannungsgrenzwerts von dem Impedanz-Kennwert ist derart gewählt, dass ein (im mathematischen Sinne) funktionaler Zusammenhang zwischen der Impedanz der Zelle oder Zellen oder eines Entladeteilprozesses der Zelle oder Zellen und dem Spanungsgrenzwert besteht.

Für diesen funktionalen Zusammenhang gilt im Allgemeinen, dass eine höhere Impedanz zu einem höheren Spannungsgrenzwert führt (Fall "höhere Impedanz entspricht höherem Spannungsgrenzwert"), aber dieser funktionale Zusammenhang kann optional Plateaus oder Stufen haben (Fall "höhere Impedanz entspricht nicht niedrigerem Spannungsgrenzwert").

Es kann sein, dass das Verfahren einen Mindestwert für den Spannungsgrenzwert vorsieht, sodass ein Tiefenentladen verhindert werden kann. Es kann außerdem sein, dass das Verfahren einen Maximalwert für den Spannungsgrenzwert vorsieht, welcher vorzugsweise niedriger als eine Nennspannung der jeweiligen Zelle / des jeweiligen Akkumulators ist. Mittels dieser Werte kann die Impedanz-Abhängigkeit mit einfachen Mitteln an eine Benutzererwartung angepasst werden.

Es kann sein, dass die Abhängigkeit des Spannungsgrenzwerts von dem zumindest einen Impedanz-Kennwert in Form einer Tabelle und/oder eines Kennfelds bzw. einer mehrdimensionalen Tabelle hinterlegt ist, um eine einfache Implementierung zu erreichen.

Es kann sein, dass a) zusätzlich zu dem Impedanz-Kennwert zumindest ein Temperaturindikator aufgezeichnet wird, welcher für eine Temperatur der Zelle während des Messens des Impedanz-Kennwerts indikativ ist, und b) der Spannungsgrenzwert auch in Abhängigkeit des Temperaturindikators bestimmt wird. Auf diese Weise kann man eine Temperaturabhängigkeit des Messens/Ermittelns des Impedanz-Kennwerts kompensieren. Dies führt zu einem präziseren Impedanz-Kennwert.

Es kann sein, dass zum Messen des Impedanz-Kennwerts ein Verfahren zur elektrochemischen Impedanzspektroskopie verwendet wird, dem vorzugsweise eine Analyse auf Basis einer Verteilungsfunktion von Relaxationszeiten nachgeschaltet ist. Diese Analyse kann man als DRT-Analyse bzw. ORT-Verfahren ("distributed relaxation times"-Verfahren) bezeichnen. Diese Methoden bzw. Verfahren sind in weitem Maße erforscht und entsprechend zuverlässig.

Es kann sein, dass der zumindest eine Impedanz-Kennwert einen Kathode-Ladungsübergang-Widerstandsindikator, einen Anode-Ladungsübergang-Widerstandsindikator, einen Passivierungsschicht-Widerstandsindikator und/oder eine Kombination aus zwei oder drei dieser Widerstandsindikatoren enthält und/oder darauf basiert. Diese Widerstandsindikatoren geben eine Zyklenzahl-bedingte Reduzierung der effektiven Kapazität der jeweiligen Zelle gut wieder. Entsprechend führt diese Variante zu einer zuverlässigen Bestimmung des Spannungsgrenzwerts.

Gemäß einem weiteren Aspekt der Erfindung wird ein Akkumulator vorgeschlagen. Der Ackumulator ist zum Versorgen einer mobilen Werkzeugmaschine, insbesondere einer tragbaren Werkzeugmaschine, mit elektrischem Strom eingerichtet, er enthält zumindest eine Zelle und eine Steuereinrichtung. Die Steuereinrichtung ist dazu eingerichtet, das vorstehend beschriebene Verfahren zum Betreiben eines Akkumulators auszuführen. Die für das vorgeschlagene Verfahren beschriebenen Ausführungsformen und Merkmale gelten für den vorgeschlagenen Akkumulator entsprechend.

Gemäß einem weiteren Aspekt der Erfindung wird eine mobile Werkzeugmaschine vorgeschlagen. Die mobile Werkezugmaschine ist vorzugsweise tragbar. Sie hat eine Schnittstelle zum Koppeln eines Akkumulators und/oder sie hat einen integrierten Akkumulator. Die Werkzeugmaschine ist dazu eingerichtet, das vorgeschlagene Verfahren zum Betreiben eines Ackumulators auszuführen. Die für das vorgeschlagene Verfahren beschriebenen Ausführungsformen und Merkmale gelten für die vorgeschlagene Werkzeugmaschine entsprechend.

Weiterhin wird ein Computerprogrammprodukt vorgeschlagen, welches Befehle umfasst, die bei der Ausführung des Programms durch einen Computer diesen veranlassen, das vorstehend beschriebene Verfahren auszuführen. Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen. Die für das vorgeschlagene Verfahren beschriebenen Ausführungsformen und Merkmale gelten für das vorgeschlagene Computerprogrammprodukt entsprechend.

Gemäß einem weiteren Aspekt der Erfindung wird ein Ladegerät vorgeschlagen. Das Ladegerät hat eine Schnittstelle und eine Steuereinrichtung. Die Schnittstelle ist zum zumindest elektrischen Koppeln eines Akkumulators eingerichtet, welcher zum Versorgen einer mobilen Werkzeugmaschine und insbesondere einer tragbaren Werkzeugmaschine mit elektrischem Strom eingerichtet ist. Die Steuereinrichtung ist dazu eingerichtet, die folgenden Schritte an einem mit der Schnittstelle gekoppelten Akkumulator auszuführen: Messen eines Impedanz-Kennwerts zumindest einer Zelle des gekoppelten Akkumulators, und a) Hinterlegen des Impedanz-Kennwerts in dem Akkumulator, und/oder b) Bestimmen eines zum Beenden eines Entladens geeigneten Spannungsgrenzwerts in Abhängigkeit des Impedanz-Kennwerts, und Hinterlegen des Spannungsgrenzwerts in dem Akkumulator. Das Ladegerät ist also nicht zum Ausführen eines Entladebetriebs des Akkumulators eingerichtet, sondern es stellt dem Akkumulator oder einer den Akkumulator später koppelnden Werkzeugmaschine den zumindest einen Impedanz-Kennwert und/oder den bereits bestimmten Spannungsgrenzwert bereit. Damit ermöglicht das Ladegerät es, dass der Akkumulator, mittels der eingangs beschriebenen Effekte und über dessen Lebensdauer betrachtet, eine erhöhte effektive Kapazität hat. Im Übrigen sind die Optionen und Varianten des eingangs beschriebenen Verfahrens auch bei diesem Ladegerät anwendbar.

Gemäß einem weiteren Aspekt der Erfindung wird ein weiterer Akkumulator vorgeschlagen. Der Akkumulator ist zum Versorgen einer mobilen Werkzeugmaschine und insbesondere einer tragbaren Werkzeugmaschine mit elektrischem Strom eingerichtet. Der Akkumulator hat zumindest eine Zelle und eine Steuereinrichtung. Die Zelle ist in einer zum Durchführen eines Messens zumindest eines Impedanz-Kennwerts geeigneten Weise verschaltet. Die Steuereinrichtung ist dazu eingerichtet, dass ein Impedanz-Kennwert und/oder ein Spannungsgrenzwert darin hinterlegbar und daraus auslesbar ist. Somit ist der Akkumulator dazu in der Lage, dass die Impedanz-Messung durch beispielsweise ein Ladegerät durchgeführt wird, und dass auf dieser Grundalge beispielsweise eine Werkezugmaschine das Entladen bei Erreichen des Spannungsgrenzwerts beenden kann. Im Übrigen sind die Optionen und Varianten des eingangs beschriebenen Verfahrens auch bei diesem Akkumulator anwendbar.

Gemäß einem weiteren Aspekt der Erfindung wird eine weitere mobile Werkzeugmaschine vorgeschlagen, welche vorzugsweise tragbar ist. Diese hat eine Schnittstelle zum Koppeln eines Akkumulators. Sie ist dazu eingerichtet, ein Entladen zumindest einer Zelle des Akkumulators bei Erreichen des ausgelesenen Spannungsgrenzwerts zu beenden, sowie zuvor a) einen in dem Akkumulator hinterlegten Impedanz-Kennwert aus dem Akkumulator auszulesen, und den zum Beenden eines Entladens geeigneten Spannungsgrenzwert in Abhängigkeit des Impedanz-Kennwerts zu bestimmen, und/oder b) den in dem Akkumulator hinterlegten Spannungsgrenzwert aus dem Akkumulator auszulesen. Indem sie das Entladen bei dem jeweiligen Spannungsgrenzwert beendet, wird die effektive Kapazität des Akkumulators erhöht, welche dieser über dessen Lebensdauer abgeben kann. Im Übrigen sind die Optionen und Varianten des eingangs beschriebenen Verfahrens auch bei dieser Werkzeugmaschine anwendbar.

Gemäß einem letzten Aspekt der Erfindung wird ein System vorgeschlagen, welches das vorgeschlagene Ladegerät, den vorgeschlagenen weiteren Akkumulator und die vorgeschlagene weitere mobile Werkzeugmaschine hat. Das System bewirkt im Zusammenwirken aus dem Ladegerät und der Werkzeugmaschine, dass die effektive Kapazität eines Akkumulators über dessen Lebensdauer erhöht wird. Im Übrigen sind die Optionen und Varianten des eingangs beschriebenen Verfahrens auch bei diesem System anwendbar.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird die Fachperson auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

### KURZE BESCHREIBUNG DER FIGUREN

Die nachfolgende Beschreibung erläutert die Erfindung anhand von exemplarischen Ausführungsformen und Figuren. In den Figuren zeigt:
- Fig. 1: schematisch eine vorgeschlagene Werkzeugmaschine, mit der ein vorgeschlagener Akkumulator gekoppelt ist;
- Fig. 2: schematisch eine Impedanz-Kennlinie eines Akkumulators;
- Fig. 3: schematisch eine umgeformte Impedanz-Kennlinie desselben Akkumulators sowie daraus abgeleitete Impedanz-Kennwerte;
- Fig. 4: schematisch eine innere Schaltung eines vorgeschlagenen Aktors;
- Fig. 5: schematisch ein Ablaufdiagramm eines vorgeschlagenen Verfahrens; und
- Fig. 6: schematisch ein System enthaltend ein Ladegerät, einen Akkumulator und eine mobile Werkzeugmaschine, die gemeinsam zum Ausführen des vorgeschlagenen Verfahrens eingerichtet sind.
Gleiche oder funktionsgleiche Elemente werden durch gleiche Bezugszeichen in den Figuren indiziert, soweit nichts anderes angegeben ist.

### AUSFÜHRUNGSFORMEN DER ERFINDUNG

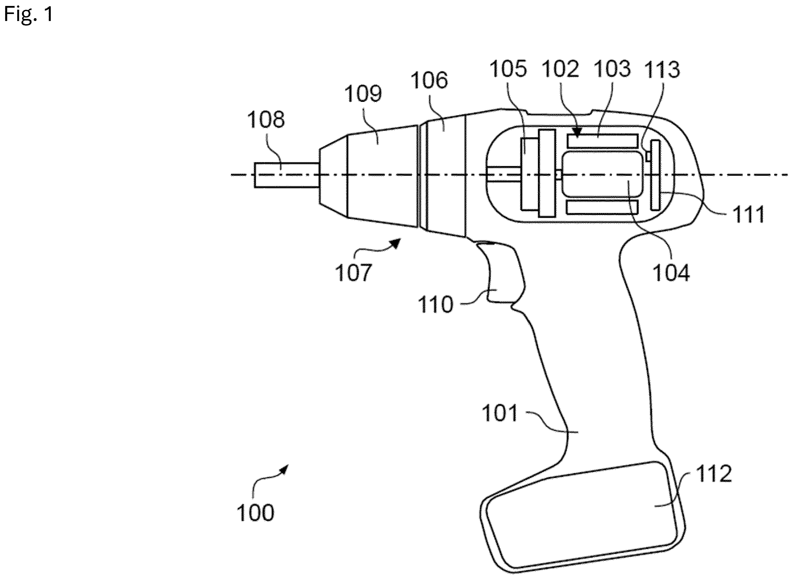

Die Fig. 1 zeigt eine mobile Werkzeugmaschine 100. Die Werkzeugmaschine 100 ist beispielhaft eine Handwerkzeugmaschine, genauer gesagt eine Bohrmaschine. Weitere bevorzugte Ausführungsformen umfassen eine Meißelmaschine, eine Schleifmaschine oder eine Sägemaschine. Die Werkzeugmaschine 100 hat ein Gehäuse 101 zum Schützen und Lagern weiterer Bauteile. Die Werkzeugmaschine 100 ist als tragbares Gerät ausgebildet. Sie weist beispielsweise ein Gewicht zwischen 0,5 und 15 kg und allgemein von weniger als 25 kg oder 50 kg auf.

Die Werkzugmaschine 100 hat einen Elektromotor 102, der einen Stator 103 und einen Rotor 104 hat. Der Rotor 104 ist beispielsweise über ein Getriebe 105 mit einer Spindel 106 einer Werkezugaufnahme 107 rotationsgekoppelt. Das Getriebe 105 ist beispielsweise ein Untersetzungsgetriebe. Es kann sein, dass das Getriebe 105 zwischen mehreren Übersetzungen schaltbar ist. Es kann sein, dass die Werkzeugmaschine 100 ein Schlagwerk enthält, das als Teil des Getriebes 105 oder der Werkzeugaufnahme 107 ausgeführt und/oder zwischen das Getriebe 105 und die Werkzeugaufnahme 107 geschaltet ist.

Die Werkzeugaufnahme 107 ist vorzugsweise zur Aufnahme eines wechselbaren Werkzeugs 108 konfiguriert. Beispielsweise kann durch ein Verdrehen eines Griffs 109 der Werkzeugaufnahme 107 gegenüber der Spindel 106 ein (nicht dargestelltes) Futter der Werkzeugaufnahme 107 geöffnet und/oder geschlossen werden. Beispielsweise handelt es sich um ein Schnellspannbohrfutter, ein SDS-Bohrfutter und/oder ein TE-C-Borfutter. Mittels der Werkzeugaufnahme 107 ist das Werkzeug 108 beispielsweise rotierend und/oder schlagend und/oder hämmernd antreibbar.

Der Elektromotor 102 ist beispielsweise ein bürstenloser Gleichstrommotor. Der Elektromotor 102 ist zum Erzeugen eines Drehmoments zwischen dem Stator 103 und dem Rotor 104 betreibbar. Eine Steuervorrichtung 111 ist dazu konfiguriert, auf eine Betätigung eines Betätigungselements 110 hin einen elektrischen Stromfluss von einer Stromquelle 112 zu dem Stator 103 zu schalten. Die Stromquelle 112 ist ein Akkumulator. Der Akkumulator 112 ist über eine (nicht gezeigte) Schnittstelle des Akkumulators 112 mit einer komplementären (ebenfalls nicht gezeigten) Schnittstelle der Werkzeugmaschine 100 elektrisch und mechanisch gekoppelt.

Beispielsweise ist die Steuervorrichtung 111 dazu eingerichtet, eine Rotationslage (Rotationswinkel und/oder Winkelgeschwindigkeit) des Rotors 104 relativ zu dem Gehäuse 101 mittels einer Hallsensorschaltung 113 zu erfassen. Beispielsweise ist die Steuervorrichtung 111 weiterhin dazu eingerichtet, (in Fig. 1 nicht dargestellte) Wicklungen des Stators 103 mit elektrischem Strom zu beaufschlagen. Die Steuervorrichtung 111 hat dazu beispielsweise eine Auswertelogik, und sie kann beispielsweise zum Ausführen eines Computerprogramms eingerichtet sein, dessen Befehle die Steuervorrichtung 111 dazu bringen, ein Verfahren zum Betreiben der mobilen Werkzeugmaschine 100 auszuführen.

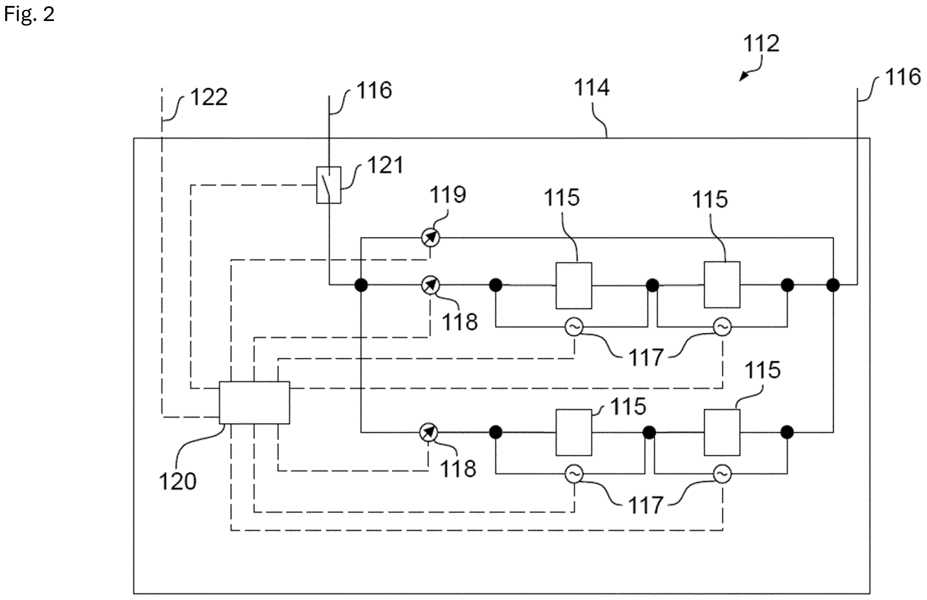

Die Fig. 2 zeigt einen beispielhaften Akkumulator 112. Der Akkumulator hat ein Gehäuse 114, das mehrere Zellen 115 einhaust. In dem gezeigten Beispiel sind je zwei Zellen 115 in Reihe und die Reihenschaltungen parallel geschaltet. Die Parallelschaltung ist mit zwei Polen 116 nach außerhalb des Gehäuses 114 geführt. Die Zellen 115 des Akkumulators 112 sind somit unveränderlich verschaltet.

Außerdem hat der Akkumulator 112 je mehrere Wechselspannungsquellen 117. Jede Wechselspannungsquelle 117 ist dazu eingerichtet und verschaltet, eine Zelle 115 mit Wechselspannung unterschiedlicher Frequenzen zu beaufschlagen.

Der Akkumulator 112 hat außerdem jeweils einen Stromstärkemesser 118 je Reihenschaltung mehrerer Zellen 115. Der Akkumulator 112 hat einen Spannungsmesser 119, welcher verschaltet ist, um eine elektrische Spannung der Parallelschaltung zu erfassen, also eine Spannung des Akkumulators 112.

Der Akkumulator 112 hat eine Steuereinrichtung 120. Die Steuereinrichtung 120 ist mit den Wechselspannungsquellen 117 und den Stromstärkemessern 118 verschaltet. Die Steuereinrichtung 120 ist dazu eingerichtet, für jede Zelle 115 jeweils einzeln zumindest einen Impedanz-Kennwert zu messen.

Der Akkumulator 112 hat einen Schalter 121, welcher zwischen einen der Pole 116 und die Zellen 115 geschaltet ist. Die Steuereinrichtung 120 ist mit dem Spannungsmesser 119 und dem Schalter 121 verschaltet. Die Steuereinrichtung 120 ist dazu eingerichtet, den Schalter 121 zu öffnen, um ein Entladen zu beenden, wenn eine Spannung des Akkumulators 112 während eines Entladens einen Spannungsgrenzwert erreicht.

Die Steuereinrichtung 120 hat zumindest einen Signalanschluss 122, der ebenfalls durch das Gehäuse 114 nach außen geführt ist. Die Pole 116 und der Signalanschluss 122 sind Teil der (nicht gezeigten) Schnittstelle des Akkumulators 112.

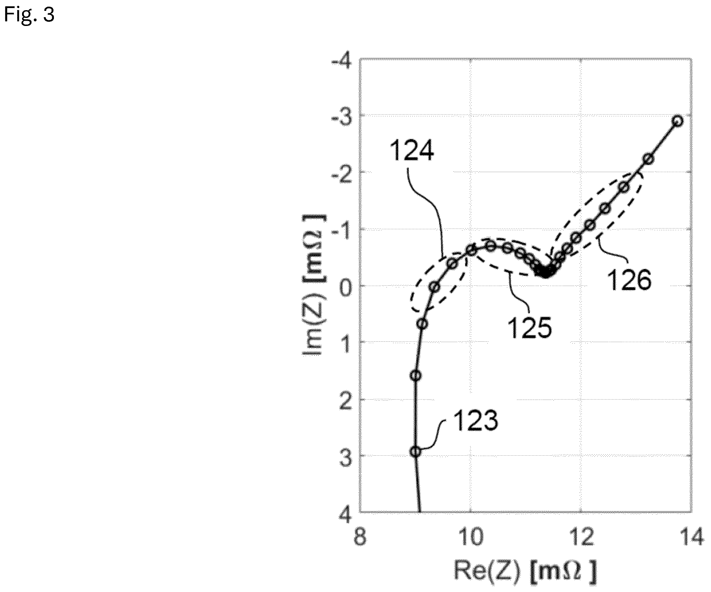

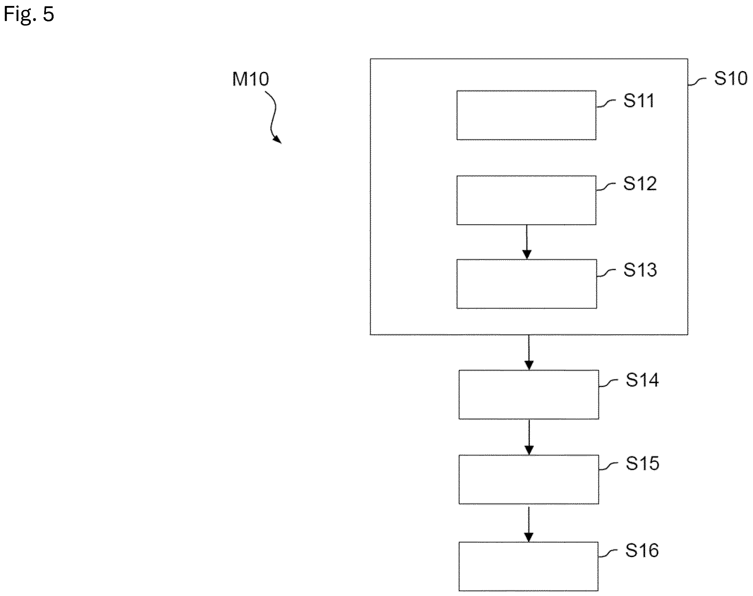

Nun wird anhand der Fig. 3 bis 5 ein Verfahren M10 zum Betreiben eines Akkumulators 112 vorgestellt. Das Verfahren M10 wird beispielsweise von der Steuereinrichtung 120 des Akkumulators 112 ausgeführt, aber es kann genauso von der Steuervorrichtung 111 der Werkzeugmaschine 100 oder einer Steuereinrichtung 134 eines Ladegeräts 133 ausgeführt werden.

In einem Schritt S10 wird zumindest ein Impedanz-Kennwert zumindest einer Zelle 115 gemessen. Der Schritt S10 wird vorzugsweise während eines Ladens des Akkumulators 112 ausgeführt, aber er kann auch in einer Betriebspause bzw. einem Bereitschaftsbetrieb oder während eines Entladebetriebs ausgeführt werden. Es kann sein, dass der Schritt S10 Ereignis-gesteuert ausgelöst wird, beispielsweise bei Erreichen einer vorgegebenen Spannung während eines Aufladens, bei Ende eines Aufladens, bei Beginn eines Entladens und/oder dergleichen. Es kann sein, dass der Schritt S10 zeitgesteuert ausgeführt wird, beispielsweise täglich, stündlich oder dergleichen.

Es ist bevorzugt, dass das Messen in S10 mindestens einmal je Ladezyklus (Aufladen und Entladen, auch teilweise) ausgeführt wird. Es kann aber auch sein, dass das Messen in S10 nicht in jedem Ladezyklus ausgeführt wird. In diesem Fall speichert beispielsweise die Steuereinrichtung 120 den zuletzt gemessenen Impedanz-Kennwert und/oder den zuletzt bestimmten Spannungsgrenzwert.

Der Schritt S10 enthält einen Unterschritt S11, in welchem eine Temperatur des Akkumulators 112 erfasst, während der Impedanz-Kennwert gemessen wird. Dier erfasste Temperatur wird als ein Temperaturindikator hinterlegt. Eine Alternative hierzu wird beispielsweise in einem Temperieren des Akkumulators 112 oder beispielsweise in einem Ausführen des Messens in einem vorgegebenen Temperaturfenster gesehen.

Der Schritt S10 hat beispielsweise einen Unterschritt S12, wobei eine elektrochemische Impedanzspektroskopie ausgeführt wird. Dabei wird durch jeweils eine der Wechselspannungsquellen 117 unter Steuerung der Steuereinrichtung 120 eine Wechselspannung auf eine der Zellen 115 aufgeprägt, und wird gleichzeitig durch die Steuereinrichtung 120 mittels des jeweiligen Stromstärkemessers 118 eine resultierende Stromstärke gemessen. Wenn dieses Messen bei unterschiedlichen Frequenzen erfolgt, erhält man mehrere Messpunkte 123.

Die Fig. 3 zeigt ein Ergebnis einer solchen Messung, wobei mehrere Messpunkte 123 in einem Koordinatensystem aus Ohm'schem Widerstand und Blindwiderstand aufgetragen sind. Zur Verdeutlichung sind die Messpunkte 123 zu einer Kurve verbunden. Man kann in dem Verlauf der Kurve mehrere Bereiche erkennen, nämlich zum Beispiel einen für eine Passivierungsschicht aussagekräftigen Bereich 124, einen für einen Ladungsübergang aussagekräftigen Bereich 125 und einen für ein Diffusionsverhalten aussagekräftigen Bereich 126. Sowohl die einzelnen Messpunkte 123, als auch die daraus gebildete Kurve, als auch die Bereiche 124, 125 und 126 können jeweils als ein Impedanz-Kennwert im oben genannten Sinn angesehen werden.

Es ist wichtig zu erwähnen, dass die vorliegende Erfindung nicht auf die elektrochemische Impedanzspektroskopie beschränkt sein soll. Vielmehr soll Schritt S10 jedes Verfahren anwenden können, das in einem Betrieb des Akkumulators ausführbar ist und zumindest einen Impedanz-Kennwert ergibt. Ein Impedanz-Kennwert kann auch ein rein Ohm'sches Verhalten beschreiben.

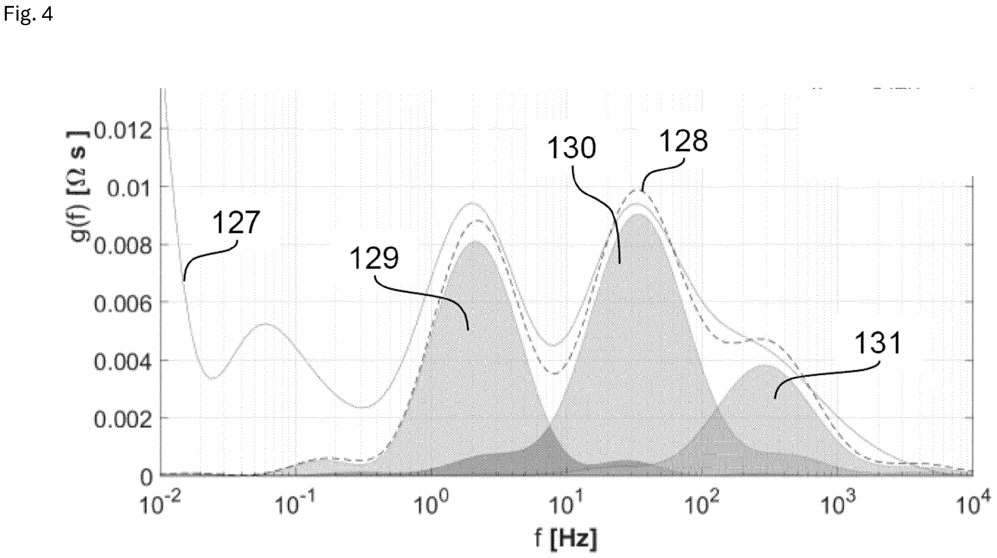

In einem Schritt S13 wird eine Analyse auf Basis einer Verteilungsfunktion von Relaxationszeiten (kurz: DRT-Analyse) durchgeführt, siehe Fig. 4. Dabei wird die Kurve der Fig. 3 in eine Impedanz-Kennlinie 127 umgewandelt. Man kann daher von einer gemessenen oder analytischen Impedanz-Kennlinie 127 sprechen. Außerdem wird mittels einer Ersatzschaltung (sog. "equivalent circuit model", ECM) eine Impedanz-Kennlinie 128 zu berechnen. Man kann von einer simulierten oder synthetischen Impedanz-Kennlinie sprechen. Mehrere Parameter der Ersatzschaltung werden variiert, um die synthetische Impedanz-Kennlinie 128 an die gemessene Impedanz-Kennlinie 127 anzupassen (sog. "ECM fit"). Diese Parameter können beispielsweise eine Kathode-Ladungsübergang-Impedanz 129 (ein Kathode-Ladungsübergang-Widerstandsindikator), eine Anode-Ladungsübergang-Impedanz 130 (ein Anode-Ladungsübergang-Widerstandsindikator) und/oder eine Passivierungsschicht-Impedanz 131 (ein Passivierungsschicht-Widerstandsindikator) sein. Die genannten Impedanzen 129 bis 131 sind jeweils als ein Impedanz-Kennwert ermittelbar, und sie sind der Fig. 4 als jeweilige Flächen entnehmbar. Der Schritt S13 ist also ein Teil des Messens des zumindest einen Impedanz-Kennwerts.

In einem Schritt S14 wird ein Spannungsgrenzwert in Abhängigkeit des Impedanz-Kennwerts bestimmt. Hierbei wird ein einziger Spannungsgrenzwert für den Akkumulator 112 ermittelt. Der Spannungsgrenzwert wird nach der Regel ermittelt, dass der Spannungsgrenzwert umso höher ist, je höher die jeweiligen Impedanz der Zelle 115 oder gemeinsame Impedanz der Zellen 115 ist. Im vorliegenden Beispiel wird eine Summe der Impedanzen 129 bis 131 als die gemeinsame Impedanz der Zellen 115 angenommen. Diese Summe wird dann mit einem Korrekturfaktor korrigiert, welcher von der in S12 gemessenen Temperatur der Zellen 115 abhängig ist. Das heißt also, je höher die Temperatur-korrigiere Summe der Impedanzen 129 bis 131 ist, umso höher ist der bestimmte bzw. errechnete Spannungsgrenzwert.

Es kann auch sein, dass für jede Zelle 115, für welche ein Impedanz-Kennwert ermittelt ist, ein jeweiliger Spannungsgrenzwert ermittelt wird. Dies wird vorzugsweise bei Akkumulatoren 112 gemacht, welche von ihrer Schaltung her dazu eingerichtet sind, die Spannung jeder einzelnen Zelle 115 dezidiert zu messen.

In einem Schritt S15 wird eine Spannung zumindest der Zelle 115 während eines Entladens bzw. eines Entladebetriebs des Akkumulators 112 ermittelt. Beispielsweise bei dem in Fig. 2 skizzierten Akkumulator 112 wird mittels des Spannungsmessers 119 eine Spannung der Reihen-und-Parallel-Schaltung der Zellen 115 überwacht.

Diese gemessene Spannung wird durch die Steuereinrichtung 120 mit dem in S14 bestimmten Spannungsgrenzwert verglichen.

In einem Schritt S16 wird das Entladen beendet, sobald die in S15 gemessene Spannung gleich niedrig wie der in S14 ermittelte Spannungsgrenzwert wird. In diesem Fall bewirkt die Steuervorrichtung 120 ein Öffnen des Schalters 121.

Somit bewirkt das Ausführen des Verfahrens M10 durch die Steuervorrichtung 120 des Ackumulators 112, dass eine effektive Kapazität des Akkumulators 112 über dessen Lebensdauer maximiert wird. Mit anderen Worten, der Akkumulator 112 ist dazu in der Lage, über dessen Lebensdauer hinweg mehr Ladung als ein Akkumulator abzugeben, welcher nicht gemäß dem Verfahren M10 betrieben wurde.

In einer nicht figürlich dargestellten Ausführungsform wird das Verfahren M10 durch eine Werkzeugmaschine 100 ausgeführt, in die ein Akkumulator 112 integriert ist.

In einer nicht figürlich dargestellten Ausführungsform wird das Verfahren M10 durch eine Werkzeugmaschine 100 ausgeführt, an welche ein Akkumulator 112 angekoppelt wird. Die Schritte S10 bis S13 werden beispielsweise beim Ankoppeln des Akkumulators 112 an die Werkzeugmaschine 100 ausgeführt. Eine andere Möglichkeit ist es, dass alle Schritte des Verfahrens M10 während eines Entladebetriebs oder während mehrerer teilentladenden Entladebetriebe nacheinander ausgeführt werden.

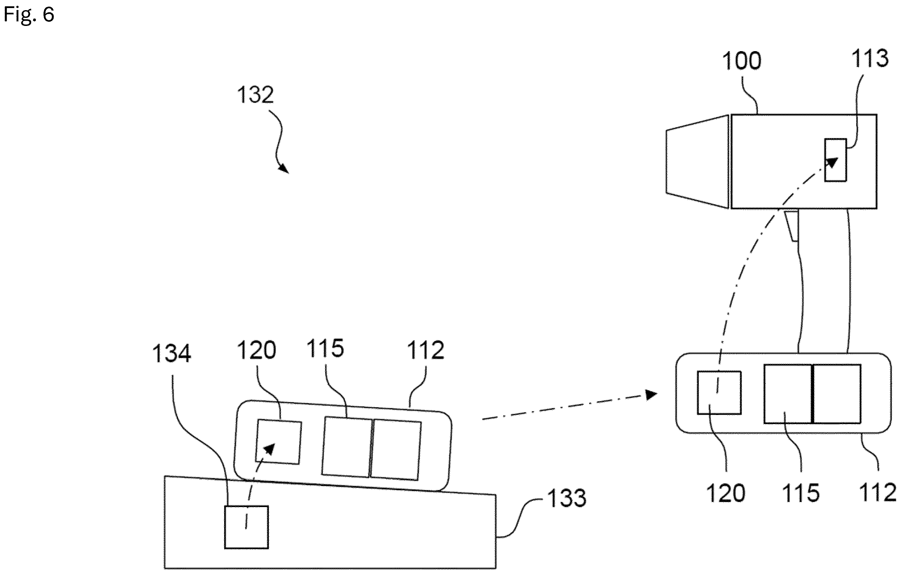

Die Fig. 6 zeigt schließlich noch ein System 132, bei dem die Verfahrensschritte auf unterschiedliche Maschinen verteilt sind. Beispielsweise werden die Schritte S10 bis S13 durch ein Ladegerät 133 ausgeführt, dessen Steuereinrichtung 134 die Messung steuert und den Impedanz-Kennwert 123, 124, 125, 126, 127, 129, 130, 131 in der Steuereinrichtung 120 des Akkumulators 112 hinterlegt. Wenn der Akkumulator 112 danach mit einer Werkezugmaschine 100 gekoppelt wird, liest dessen Steuereinrichtung 113 die Impedanz-Kennwerte 123, 124, 125, 126, 127, 129, 130, 131 aus und führt in der Folge die Schritte S14 bis S16 aus. Es kann beispielsweise auch sein, dass das Ladegerät die Schritte S10 bis S14 ausführt, den Spannungsgrenzwert in dem Akkumulator hinterlegt, die Werkzeugmaschine 100 den Spannungsgrenzwert ausliest, und dann die Werkzeugmaschine 100 die Schritte S15 und S16 ausführt. Es ist auch eine Kombination dieser Varianten denkbar, wobei beispielsweise der zumindest eine Impedanz-Kennwert 123, 124, 125, 126, 127, 129, 130, 131 und der Spannungsgrenzwert in dem Akkumulator 112 hinterlegt und ausgelesen werden.

Obwohl die vorliegende Erfindung anhand von Ausführungsbeispielen beschrieben wurde, ist sie vielfältig modifizierbar.

### BEZUGSZEICHENLISTE

- 100: mobile Werkzeugmaschine
- 101: Gehäuse der Werkzeugmaschine
- 102: Elektromotor
- 103: Stator
- 104: Rotor
- 105: Getriebe
- 106: Spindel
- 107: Werkzeugaufnahme
- 108: Werkzeug
- 109: Griff
- 110: Betätigungselement
- 111: Steuervorrichtung der Werkzeugmaschine
- 112: Stromquelle
- 113: Hallsensorschaltung
- 114: Gehäuse des Akkumulators
- 115: Zelle
- 116: Pol
- 117: Wechselspannungsquelle
- 118: Stromstärkemesser
- 119: Spannungsmesser
- 120: Steuereinrichtung des Akkumulators
- 121: Schalter
- 122: Signalanschluss
- 123: Messpunkt
- 124: Bereich, der für eine Passivierungsschicht aussagekräftig ist
- 125: Bereich, der für einen Ladungsübergang aussagekräftig ist
- 126: Bereich, der für ein Diffusionsverhalten aussagekräftig ist
- 127: umgewandelte Impedanz-Kennlinie
- 128: synthetische Impedanz-Kennlinie
- 129: Kathode-Ladungsübergang-Widerstandsindikator
- 130: Anode-Ladungsübergang-Widerstandsindikator
- 131: Passivierungsschicht-Widerstandsindikator
- 132: System
- 133: Ladegerät
- 134: Steuereinrichtung des Ladegeräts
- M10: Verfahren zum Betrieben eines Akkumulators
- S10: Messen eines Impedanz-Kennwerts zumindest einer Zelle
- S11: Verwenden eines Verfahrens zur elektrochemischen Impedanzspektroskopie
- S12: Aufzeichnen eines Temperaturindikators
- S13: Durchführen einer Analyse auf Basis einer Verteilungsfunktion von Relaxationszeiten
- S14: Bestimmen eines Spannungsgrenzwerts
- S15: Ermitteln einer Spannung zumindest der Zelle
- S16: Beenden eines Entladens

## Patentansprüche

1. Verfahren (M10) zum Betreiben eines Akkumulators (112), welcher zum Versorgen einer mobilen Werkzeugmaschine (100), insbesondere einer tragbaren Werkzeugmaschine (100), mit elektrischem Strom eingerichtet ist, enthaltend:
Messen (S10) eines Impedanz-Kennwerts (123, 124, 125, 126, 127, 129, 130, 131) zumindest einer Zelle (115) des Akkumulators (112), und
Beenden (S16) eines Entladens zumindest der Zelle (115) bei Erreichen eines Spannungsgrenzwerts, welcher in Abhängigkeit des Impedanz-Kennwerts (123, 124, 125, 126, 127, 129, 130, 131) bestimmt (S14) ist.

2. Verfahren nach Anspruch 1, wobei der Impedanz-Kennwert (123, 124, 125, 126, 127, 129, 130, 131) während eines Aufladens, während eines Bereitschaftsbetriebs und/oder während eines Entladens gemessen (S10) wird.

3. Verfahren nach Anspruch 1 oder 2, welches durch eine Akkumulator-interne Steuereinrichtung (120) ausgeführt wird.

4. Verfahren nach einem der vorigen Ansprüche, wobei der Akkumulator (115) eine unveränderliche Schaltung mehrerer Zellen (115) hat, wobei a) der Impedanz-Kennwert (123, 124, 125, 126, 127, 129, 130, 131) für zumindest eine Zelle (115) je einzeln gemessen wird, b) für jede Zelle (115), deren Impedanz-Kennwert (123, 124, 125, 126, 127, 129, 130, 131) gemessen ist, ein jeweiliger Spannungsgrenzwert bestimmt wird, und c) das Entladen beendet (S16) wird, falls eine Spannung einer Zelle (115) deren Spannungsgrenzwert erreicht.

5. Verfahren nach einem der Ansprüche 1 bis 3, wobei der Akkumulator (112) eine unveränderliche Schaltung mehrerer Zellen (115) hat, wobei a) der Impedanz-Kennwert (123, 124, 125, 126, 127, 129, 130, 131) für mehrere oder alle Zellen (115) des Akkumulators (112) gemeinsam gemessen wird, b) für alle Zellen (115), deren Impedanz-Kennwert (123, 124, 125, 126, 127, 129, 130, 131) gemessen ist, ein gemeinsamer Spannungsgrenzwert bestimmt wird, und c) das Entladen des Akkumulators (112) bei Erreichen des Spannungsgrenzwerts beendet (S16) wird.

6. Verfahren nach einem der vorigen Ansprüche, wobei die Abhängigkeit des Spannungsgrenzwerts von dem Impedanz-Kennwert (123, 124, 125, 126, 127, 129, 130, 131) bedeutet, dass eine höhere Impedanz (123, 129, 130, 131) der Zelle (115) einem zumindest nicht niedrigeren und vorzugsweise höheren Spannungsgrenzwert entspricht.

7. Verfahren nach einem der vorigen Ansprüche, wobei a) zusätzlich zu dem Impedanz-Kennwert (123, 124, 125, 126, 127, 129, 130, 131) zumindest ein Temperaturindikator aufgezeichnet wird (S11), welcher für eine Temperatur der Zelle (115) während des Messens (S10) des Impedanz-Kennwerts (123, 124, 125, 126, 127, 129, 130, 131) indikativ ist, und b) der Spannungsgrenzwert auch in Abhängigkeit des Temperaturindikators bestimmt (S14) wird.

8. Verfahren nach einem der vorigen Ansprüche, wobei zum Messen des Impedanz-Kennwerts (123, 124, 125, 126, 127, 129, 130, 131) ein Verfahren zur elektrochemischen Impedanzspektroskopie verwendet wird (S12), dem vorzugsweise eine Analyse (S13) auf Basis einer Verteilungsfunktion von Relaxationszeiten nachgeschaltet ist.

9. Verfahren nach Anspruch 8, wobei der Impedanz-Kennwert (123, 124, 125, 126, 127, 129, 130, 131) einen Kathode-Ladungsübergang-Widerstandsindikator (129), einen Anode-Ladungsübergang-Widerstandsindikator (130), einen Passivierungsschicht-Widerstandsindikator (131) und/oder eine Kombination aus zwei oder drei dieser Widerstandsindikatoren (129, 130, 131) enthält und/oder darauf basiert.

10. Akkumulator (112), welcher zum Versorgen einer mobilen Werkzeugmaschine (100), insbesondere einer tragbaren Werkzeugmaschine, mit elektrischem Strom eingerichtet ist, enthaltend zumindest eine Zelle (115) und eine Steuereinrichtung (120), welche dazu eingerichtet ist, das Verfahren (M10) nach einem der Ansprüche 1 - 9 auszuführen.

11. Mobile Werkzeugmaschine (100), insbesondere tragbare Werkzeugmaschine, die eine Schnittstelle zum Koppeln eines Akkumulators (112) und/oder einen integrierten Akkumulator hat, wobei die Werkzeugmaschine (100) dazu eingerichtet ist, das Verfahren (M10) nach einem der Ansprüche 1 - 9 auszuführen.

12. Ladegerät (133), enthaltend eine Schnittstelle zum zumindest elektrischen Koppeln eines Akkumulators (112), welcher zum Versorgen einer mobilen Werkzeugmaschine (100) und insbesondere einer tragbaren Werkzeugmaschine mit elektrischem Strom eingerichtet ist, und eine Steuereinrichtung (134), welche zum Ausführen der folgenden Schritte an einem gekoppelten Akkumulator (112) eingerichtet ist:
Messen (S10) eines Impedanz-Kennwerts (123, 124, 125, 126, 127, 129, 130, 131) zumindest einer Zelle (115) des gekoppelten Akkumulators (112), und
a) Hinterlegen des Impedanz-Kennwerts (123, 124, 125, 126, 127, 129, 130, 131) in dem Akkumulator (112), und/oder
b) Bestimmen (S14) eines zum Beenden (S16) eines Entladens geeigneten Spannungsgrenzwerts in Abhängigkeit des Impedanz-Kennwerts (123, 124, 125, 126, 127, 129, 130, 131), und Hinterlegen des Spannungsgrenzwerts in dem Akkumulator (112).

13. Akkumulator (112), welcher zum Versorgen einer mobilen Werkzeugmaschine (100) und insbesondere einer tragbaren Werkzeugmaschine mit elektrischem Strom eingerichtet ist, enthaltend zumindest eine Zelle (115), die zum Durchführen eines Messens (S10) zumindest eines Impedanz-Kennwerts (123, 124, 125, 126, 127, 129, 130, 131) verschaltet ist, und eine Steuereinrichtung (120), welche dazu eingerichtet ist, dass ein Impedanz-Kennwert (123, 124, 125, 126, 127, 129, 130, 131) und/oder ein Spannungsgrenzwert darin hinterlegbar und daraus auslesbar ist.

14. Mobile Werkzeugmaschine (100), insbesondere tragbare Werkzeugmaschine, die eine Schnittstelle zum Koppeln eines Akkumulators (112) hat, wobei die Werkzeugmaschine (100) dazu eingerichtet ist,
ein Entladen zumindest einer Zelle (115) des Akkumulators (112) bei Erreichen eines Spannungsgrenzwerts zu beenden (S16), sowie zuvor
a) einen in dem Akkumulator (112) hinterlegten Impedanz-Kennwert (123, 124, 125, 126, 127, 129, 130, 131) aus dem Akkumulator (112) auszulesen, und den zum Beenden (S16) eines Entladens geeigneten Spannungsgrenzwert in Abhängigkeit des Impedanz-Kennwerts (123, 124, 125, 126, 127, 129, 130, 131) zu bestimmen, und/oder
b) den in dem Akkumulator (112) hinterlegten Spannungsgrenzwert aus dem Akkumulator (112) auszulesen.

15. System (132), enthaltend das Ladegerät (133) nach Anspruch 12, den Akkumulator (112) nach Anspruch 13 und die mobile Werkzeugmaschine (100) nach Anspruch 14.
